(19) Europäisches Patentamt
European Patent Office
Office européen des brevets

(11) **EP 4 764 517 A1**

(12) **EUROPEAN PATENT APPLICATION**

(43) Date of publication:
**24.06.2026 Bulletin 2026/26**

(21) Application number: **25206434.0**

(22) Date of filing: **02.10.2025**

(51) International Patent Classification (IPC):
**G01R 31/26** (2020.01)   **H10P 74/20** (2026.01)
**H10P 74/00** (2026.01)

(52) Cooperative Patent Classification (CPC):
**G01R 31/2621; G01R 31/2601; G01R 31/2644**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **23.12.2024 KR 20240193542**

(71) Applicant: **Korea University Research and Business Foundation, Sejong Campus Sejong-si 30019 (KR)**

(72) Inventors:
• **LEE, Jae Woo**
  **30019 Sejong-si (KR)**
• **YOON, Inkyu**
  **30019 Sejong-si (KR)**
• **KIM, Donghyun**
  **30019 Sejong-si (KR)**
• **KIM, Sang Hyeok**
  **30019 Sejong-si (KR)**
• **LEE, Somi**
  **30019 Sejong-si (KR)**

(74) Representative: **V.O.**
  **P.O. Box 87930**
  **2508 DH Den Haag (NL)**

(54) **TEG DEVICE AND CRYOGENIC INTRINSIC CHARACTERISTICS ANALYSIS METHOD FOR QUANTITATIVE EVALUATION FOR IMPACT OF HIGH-K BASED PASSIVATION LAYER ON ELECTRICAL PROPERIES OF 2D FET STRUCTURE**

(57) Provided are a test element group (TEG) device and a cryogenic intrinsic characteristic analysis method for quantitatively assessing impact of a high-k-based passivation layer on an electrical characteristic of a device in a two-dimensional (2D) field effect transistor (FET) structure. Herein, to analyze a FET device that includes a channel of a two-dimensional (2D) material and a passivation layer of a high-k material, a first FET device in which the passivation layer is arranged in a first direction with respect to the channel and a second FET device in which the passivation layer is arranged in a second direction different from the first direction with respect to the channel may be prepared. The first charge amount trapped in the passivation layer in the first FET device and the second charge amount trapped in the passivation layer in the second FET device may be compared to assess quantitative impact of the shape of the passivation layer on the FET device.

FIG. 4

```
Start
  ↓
Prepare first FET device, second FET device, and third FET device — 410
  ↓
Analyze intrinsic characteristics of passivation layer using
cryogenic measurement and equivalent circuit according to shape of
passivation layer, with respect to each of first FET device
and second FET device — 420
  ↓
Assess quantitative impact of shape of passivation layer on FET
device through first FET device, second FET device,
and third FET device — 430
  ↓
End
```

**EP 4 764 517 A1**

**Description**

BACKGROUND

1. Field of the Invention

Example embodiments of the present disclosure relate to a test element group (TEG) device and a cryogenic intrinsic characteristic analysis method for quantitatively assessing impact of a pattern shape of a high-k-based passivation layer on an electrical characteristic of a device in a field effect transistor (FET) structure using a two-dimensional (2D) material as a channel. This patent was supported by the NRF(RS-2023-00280841).

2. Description of the Related Art

Due to limitations in physical scaling down of silicon-based devices, various channel materials are currently being studied. Among them, two-dimensional (2D) materials are receiving extensive research due to their advantages of near-two-dimensional thickness and fewer interface traps. A passivation layer is required to improve the performance of a device using a 2D material as a channel. Accordingly, there is a need for quantitative analysis regarding how electrical characteristic changes according to the shape of a passivation layer.

SUMMARY

The present disclosure provides a structure of a test element group (TEG) device for analysis and a method of quantitively assessing characteristics excluding the temperature-dependent effect through cryogenic direct current (DC) measurement.

The present disclosure provides a TEG device and a cryogenic intrinsic characteristic analysis method for quantitatively assessing impact of a pattern shape of a high-k-based passivation layer on an electrical characteristic of a device in a two-dimensional (2D) field effect transistor (FET) structure.

Herein, an operating method of an electronic device for analyzing a FET device that includes a channel of a 2D material and a passivation layer of a high-k material may include preparing a first FET device in which the passivation layer is arranged in a first direction with respect to the channel and a second FET device in which the passivation layer is arranged in a second direction different from the first direction with respect to the channel; and comparing the first charge amount trapped in the passivation layer in the first FET device and the second charge amount trapped in the passivation layer in the second FET device, and assessing quantitative impact of the shape of the passivation layer on the FET device.

Herein, the operating method of the electronic device may further include measuring a drain voltage and a drain current at low temperature with respect to each of the first FET device and the second FET device; detecting resistance values in the passivation layer from the drain voltage and the drain current using an equivalent circuit according to the shape of the passivation layer with respect to each of the first FET device and the second FET device; and quantitatively analyzing the mobility change in the channel based on an increase ratio of the resistance values with respect to each of the first FET device and the second FET device, and the increase ratio of the resistance values may represent a ratio of a resistance value of a region covered by the passivation layer of the channel to a resistance value of a region exposed from the passivation layer of the channel.

Herein, an electronic device for analyzing a FET device that includes a channel of a 2D material and a passivation layer of a high-k material may include a memory; and a processor configured to connect to the memory and to execute at least one instruction stored in the memory, and the processor may be configured to prepare a first FET device in which the passivation layer is arranged in a first direction with respect to the channel and a second FET device in which the passivation layer is arranged in a second direction different from the first direction with respect to the channel, and to compare the first charge amount trapped in the passivation layer in the first FET device and the second charge amount trapped in the passivation layer in the second FET device, and assess quantitative impact of the shape of the passivation layer on the FET device.

Herein, the processor may be configured to measure a drain voltage and a drain current at low temperature with respect to each of the first FET device and the second FET device, to detect resistance values in the passivation layer from the drain voltage and the drain current using an equivalent circuit according to the shape of the passivation layer with respect to each of the first FET device and the second FET device, and to quantitatively analyze the mobility change in the channel based on an increase ratio of the resistance values with respect to each of the first FET device and the second FET device, and the increase ratio of the resistance values may represent a ratio of a resistance value of a region covered by the passivation layer of the channel to a resistance value of a region exposed from the passivation layer of the channel.

According to the present disclosure, by quantitatively comparing and analyzing the impact of the shape of a passivation layer, which is essential in a FET device using a 2D material as a channel, on an electrical characteristic of the FET device, it is possible to find the shape of the passivation layer having an optimal electrical characteristic, which may lead to optimization of the FET device.

BRIEF DESCRIPTION OF THE DRAWINGS

These and/or other aspects, features, and advantages of the invention will become apparent and more readily appreciated from the following description of embodiments, taken in conjunction with the accompanying drawings of which:

FIG. 1, (a), (b), and (c), schematically illustrate a first field effect transistor (FET) device according to various example embodiments;
FIG. 2, (a), (b), and (c), schematically illustrate a second FET device according to various example embodiments;
FIG. 3 is a diagram schematically illustrating an electronic device according to various example embodiments;
FIG. 4 is a flowchart schematically illustrating an operating method of an electronic device according to various example embodiments;
FIG. 5 is a flowchart illustrating an intrinsic characteristic analysis operation of FIG. 4 in detail; and

FIG. 6 is a flowchart illustrating a quantitative impact assessment operation of FIG. 4 in detail.

DETAILED DESCRIPTION

Hereinafter, the present disclosure provides a test element group (TEG) device and a cryogenic intrinsic characteristic analysis method for quantitatively assessing impact of a pattern shape of a high-k-based passivation layer on an electrical characteristic of a device in a field effect transistor (FET) structure using a two-dimensional (2D) material as a channel. Here, the present disclosure utilizes cryogenic direct current (DC) measurement to quantitatively analyze the impact of the corresponding pattern shape and employs resistance and capacitance equivalent circuits that vary depending on the structure of the passivation layer.
Hereinafter, various example embodiments of the present disclosure are described with reference to the accompanying drawings.

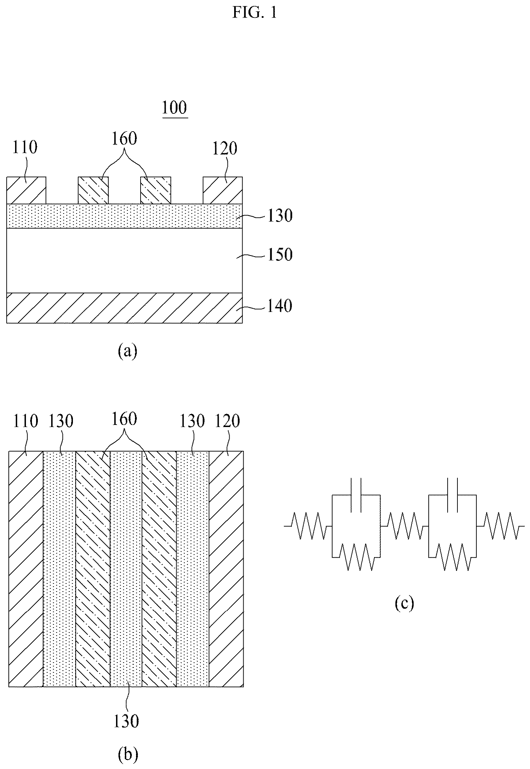

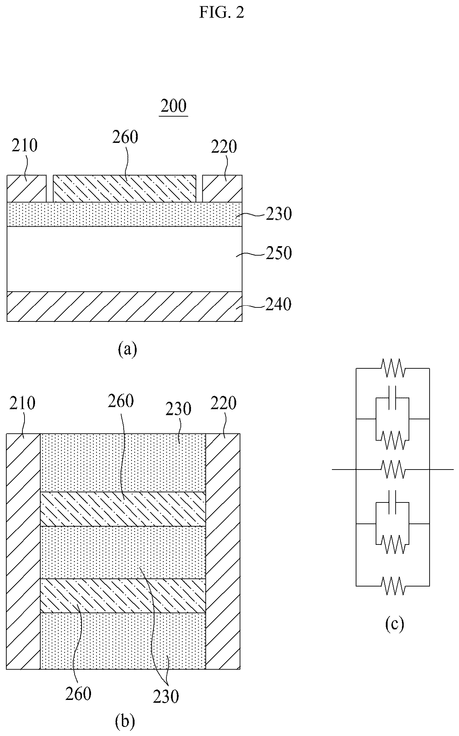

FIG. 1, (a), (b), and (c), schematically illustrate a FET device 100 according to various example embodiments. FIG. 2, (a), (b), and (c), schematically illustrate a second FET device 200 according to various example embodiments. In FIGS. 1 and 2, (a) is a cross-sectional view, (b) is a plan view, and (c) is an equivalent circuit diagram.
Referring to FIGS. 1 and 2, the first FET device 100 and the second FET device 200 may include source electrodes 110 and 210, drain electrodes 120 and 220, channels 130 and 230, gate electrodes 140 and 240, insulating electrodes 150 and 250, and passivation layers 160 and 260, respectively. The source electrode 110, 210 may serve to supply charges. The drain electrode 120, 220 may serve to receive charges. The channel 130, 230 may serve as a passage through which charges move, and may be formed of a 2D material. The gate electrode 140, 240 may serve to apply a voltage to turn on the channel 130, 230. The insulating electrode 150, 250 may serve as a gate insulating film, and may serve to block a leakage current into the gate electrode 140, 240 and may act as capacitance. The passivation layer 160, 260 may be provided to improve the device performance and to protect the 2D material of the channel 130, 230, and may be formed of a high-k material.
In various example embodiments, the first FET device 100 and the second FET device 200 may be implemented identically except for the shapes of the passivation layers 160 and 260. As shown in FIG. 1, in the first FET device 100, the passivation layer 160 may be arranged in a first direction with respect to the channel 130. Meanwhile, as shown in FIG. 2, in the second FET device 200, the passivation layer 260 may be arranged in a second direction different from the first direction with respect to the channel 230. In some example embodiments, the first direction may be defined as a vertical direction that extends parallel to the source electrode 110, 210 and the drain electrode 120, 220 between the source electrode 110, 210 and the drain electrode 120, 220, and the second direction may be defined as a horizontal direction that extends across from the source electrode 110, 210 to the drain electrode 120, 220 between the source electrode 110, 210 and the drain electrode 120, 220.

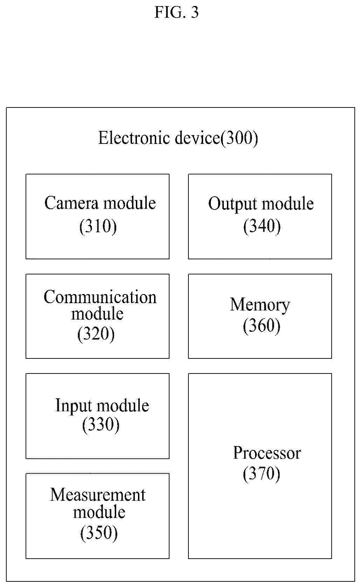

FIG. 3 schematically illustrates an electronic device 300 according to various example embodiments.
Referring to FIG. 3, the electronic device 300 relates to analyzing a FET device that includes a channel of a 2D material and a passivation layer of a high-k material, and may include at least one of a camera module 310, a communication module 320, an input module 330, an output module 340, a measurement module 350, a memory 360, and a processor 370. In some example embodiments, at least one (e.g., camera module 310, communication module 320) of the components of the electronic device 300 may be omitted, and at least one another component may be added. In some example embodiments, at least two of the components of the electronic device 100 may be implemented into a single integrated circuitry. In some example embodiments, the components of the electronic device 300 may be provided to at least two devices in a distributed manner. Here, the corresponding devices may be connected to be communicable with each other.

The camera module 310 may capture an image in the electronic device 300. Here, the camera module 310 may be a red, green, blue (RGB) camera, but is not limited thereto. For example, the camera module 310 may include at least one of a lens, an image sensor, an image signal processor, and a flash.

The communication module 320 may perform communication with an external device (not shown) in the electronic device 300. The communication module 320 may establish a communication channel between the electronic device 100 and the external device, and may perform communication with the external device through the communication channel. For example, the external device may include at least one of an electronic device, a base station, a server, and a satellite. The communication module 320 may include at least one of a wired communication module and a wireless communication module. For example, the wireless communication module may perform communication with the external device through at least one of a long-range communication network and a short-range communication network.

The input module 330 may input an instruction to be used to at least one component of the electronic device 300. The input module 330 may include at least one of an input unit configured to allow a user to directly input an instruction or data to the electronic device 300, and a sensor unit configured to detect a surrounding environment and to generate data. For example, the input unit may include at least one of a microphone, a mouse, and a keyboard. In some example embodiments, the input unit may include at least one of a touch circuitry set to detect a touch, and a sensor circuitry set to measure intensity of force generated by the touch.

The output module 340 may output information to the outside of the electronic device 300. The output module 340 may include at least one of a display module configured to visually output information, and an audio module configured to auditorily output information. For example, the display module may include at least one of a display, a hologram device, and a projector. In some example embodiments, the display module may be implemented as a touch screen through combination with at least one of the touch circuitry and the sensor circuitry of the input module 330. For example, the audio module may include at least one of a speaker and a receiver.

The measurement module 350 may perform measurement on the FET device. To this end, the measurement module 350 may contact at least one point of the FET device.

The memory 360 may store a variety of data used by at least one component of the electronic device 300. For example, the memory 360 may include at least one of a volatile memory and a nonvolatile memory. Data may include a program or input data or output data for an instruction related to the program. The program may be stored as software in the memory 360, and may include at least one of an operating system, middleware, and an application.

The processor 370 may control at least one component of the electronic device 300 by executing the program of the memory 360. Through this, the processor 370 may perform data processing or operation. Here, the processor 170 may execute the instruction stored in the memory 360.

In various example embodiments, the processor 370 may quantitatively assess the impact of the shape of the passivation layer 160, 260 that affects the FET device through the first FET device 100, the second FET device 200, and a third FET device (not shown) without a passivation layer. Here, the third FET device may be implemented identically to the first FET device 100 and the second FET device 200 except for absence of the passivation layer, that is, may include a channel formed of a 2D material. In detail, the processor 370 may compare the first charge amount trapped in the passivation layer 160 in the first FET device 100 and the second charge amount trapped in the passivation layer 260 in the second FET device 200, and may assess the quantitative impact of the shape of the passivation layer on the FET device.

In various example embodiments, the processor 370 may analyze intrinsic characteristics of the passivation layers 160 and 260 using cryogenic (e.g., 100 K to 300 K) measurement and equivalent circuits according to the shape of the passivation layers 160 and 260 with respect to the first FET device 100 and the second FET device 200, respectively. In detail, the processor 370 may detect resistance values in the passivation layer 160, 260 from a drain voltage and a drain current measured at low temperature using the equivalent circuit according to the shape of the passivation layer 160, 260, and may quantitatively analyze the mobility change in the channel 130, 230 based on an increase ratio of the resistance values, with respect to each of the first FET device 100 and the second FET device 200.

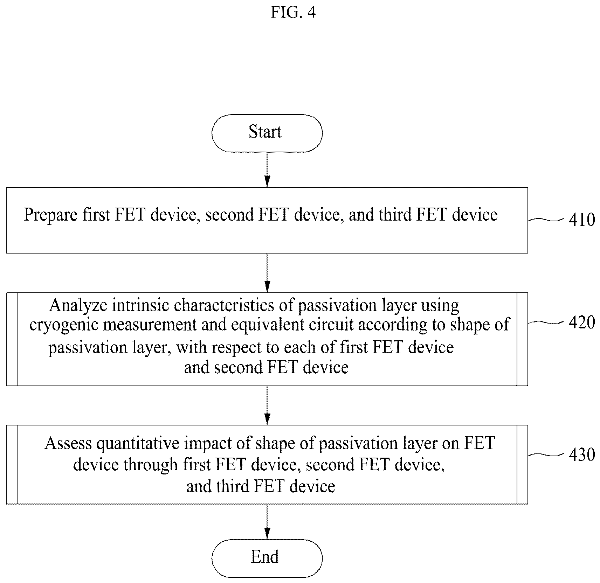

FIG. 4 is a flowchart schematically illustrating an operating method of the electronic device 300 according to various example embodiments.

Referring to FIG. 4, in operation 410, the first FET device 100, the second FET device 200, and the third FET device may be prepared. As described above, the first FET device 100 and the second FET device 200 may include the channels 130 and 230 formed of the 2D material and the passivation layers 160 and 260 formed of the high-k material, respectively, and may be implemented identically except for the shapes of the passivation layers 160 and 260. Here, as shown in FIG. 1, in the first FET device 100, the passivation layer 160 may be arranged in the first direction with respect to the channel 130. Meanwhile, as shown in FIG. 2, in the second FET device 200, the passivation layer 260 may be arranged in the second direction different from the first direction with respect to the channel 230. In some example embodiments, the first direction may be defined as the vertical direction that extends parallel to the source electrode 110, 210 and the drain electrode 120, 220 between the source electrode 110, 210 and the drain electrode 120, 220, and the second direction may be defined as the vertical direction that extends across from the source electrode 110, 210 to the drain electrode 120, 220 between the source electrode 110, 210 and the drain electrode 120, 220. Meanwhile, the third FET device may be implemented identically to the first FET device 100 and second the FET device 200 except that the third FET device does not include the passivation layer, that is, may include the channel formed of the 2D material.

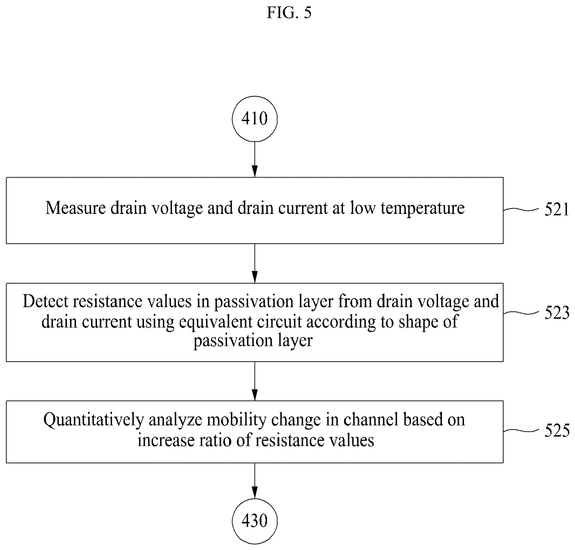

In operation 420, the electronic device 300 may analyze intrinsic characteristics of the passivation layers 160 and 260 using cryogenic measurement and the equivalent circuits according to the shape of the passivation layers 160 and 260, with respect to the first FET device 100 and the second FET device 200, respectively. In detail, the processor 370 may detect resistance values in the passivation layer 160, 260 from a drain voltage and a drain current measured at low temperature using the equivalent circuit according to the shape of the passivation layer 160, 260, and may quantitatively analyze the mobility change in the channel 130, 230 based on an increase ratio of the resistance values with respect to each of the first FET device 100 and the second FET device 200. This is further described with reference to FIG. 5.

FIG. 5 is a flowchart illustrating an intrinsic characteristic analysis operation (operation 420) of FIG. 4 in detail.

Referring to FIG. 5, in operation 521, the processor 370 may measure a drain voltage and a drain current at low temperature with respect to each of the first FET device 100 and the second FET device 200.

In operation 523, the processor 370 may detect resistance values ($R_1$ and $R_2$) in the passivation layer 160, 260 from the drain voltage and the drain current using the equivalent circuit according to the shape of the passivation layer 160, 260 with respect to each of the first FET device 100 and the second FET device 200. Here, the resistance values may include a resistance value ($R_1$) of a region exposed from the passivation layer 160, 260 of the channel 130, 230 and a resistance value ($R_2$) of a region covered by the passivation layer 160, 260 of the channel 130, 230. Here, the equivalent circuit of the first FET device 100 may be expressed as [Equation 1] below, and the equivalent circuit of the second FET device 200 may be expressed as [Equation 2] below. Therefore, the processor 370 may detect the resistance values ($R_1$ and $R_2$) based on [Equation 1] and [Equation 2] below.

[Equation 1]

$$\frac{V_D}{I_D} = R_{tot} = 3R_1 + 2R_2$$

[Equation 2]

$$\frac{V_D}{I_D} = \frac{1}{R_{tot}} = \frac{3}{R_1} + \frac{2}{R_2}$$

Here, $V_D$ denotes the drain voltage, $I_D$ denotes the drain current, $R_{tot}$ denotes a total resistance value, $R_1$ denotes the resistance value of the region exposed from the passivation layer 160, 260 of the channel 130, 230, and $R_2$ denotes the resistance value of the region covered by the passivation layer 160, 260 of the channel 130, 230.

In operation 525, the processor 370 may quantitatively analyze the mobility change in the channel 130, 230 based on an increase ratio of the resistance values ($R_1$ and $R_2$). Here, the increase ratio of the resistance values ($R_1$ and $R_2$) may represent a ratio (i.e., $R_2/R_1$) of the resistance value ($R_2$) of the region covered by the passivation layer 160, 260 of the channel 130, 230 to the resistance value ($R_1$) of the region exposed from the passivation layer 160, 260 of the channel 130, 230. Since $R_1$ represents the resistance value of the region exposed from the passivation layer 160, 260 of the channel 130, 230, and $R_2$ represents the resistance value of the region covered by the passivation layer 160, 260 of the channel 130, 230, the passivation layer 160, 260 may increase $R_2$, which leads to increasing $R_2/R_1$ and the overall increase in resistance. The increase in resistance indicates that electrons are more impeded when the electrons move from the source electrode 110, 210 to the drain electrode 120, 220, which may indicate a decrease in mobility representing how well electrons move within the channel 130, 230. Finally, due to the decrease in mobility, a current decreases according to Ohm's law (current is proportional to mobility), which may lead to degrading the performance at the product level. Then, the process may return to FIG. 4 and operation 430 may be performed.

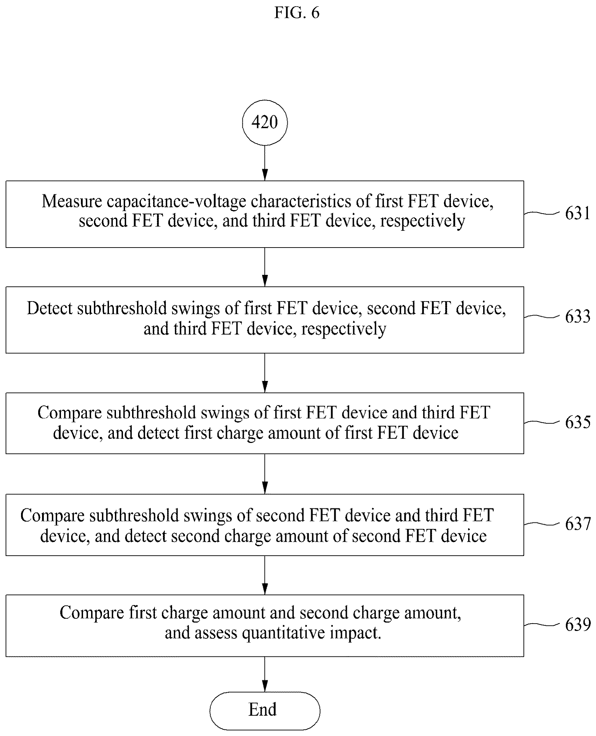

Referring again to FIG. 4, in operation 430, the electronic device 300 may assess the quantitative impact of the shape of the passivation layer 160, 260 on the FET device through the first FET device 100, the second FET device 200, and the third FET device (not shown) without the passivation layer. In detail, the processor 370 may compare the first charge amount trapped in the passivation layer 160 in the first FET device 100 and the second charge amount trapped in the passivation layer 260 in the second FET device 200, and may assess the quantitative impact of the shape of the passivation layer 160, 260 on the FET device. It is further described with reference to FIG. 6.

FIG. 6 is a flowchart illustrating a quantitative impact assessment operation (operation 430) of FIG. 4 in detail.

Referring to FIG. 6, in operation 631, the processor 370 may measure capacitance-voltage characteristics of the first FET device 100, the second FET device 200, and the third FET device, respectively. In operation 633, the processor 370 may detect subthreshold swings (SSs) of the first FET device 100, the second FET device 200, and the third FET device using the capacitance-voltage characteristics, respectively. In detail, the processor 370 may detect the subthreshold swing of the third FET device as shown in [Equation 3] below. Meanwhile, the processor 370 may detect the subthreshold swing of each of the first FET device 100 and the second FET device 200 as shown in [Equation 4] below.

[Equation 3]

$$SS_1 = 2.3kT\left(1 + \frac{C_B + C_1}{C_{OX}}\right)$$

[Equation 4]

$$SS_2 = 2.3kT\left(1 + \frac{C_B + C_2}{C_{OX}}\right)$$

Here, $SS_1$ denotes the subthreshold swing of the third FET device, $SS_2$ denotes the subthreshold swing of the first FET device 100 or the second FET device 200, kT denotes Boltzmann constant, $C_B$ denotes capacitance of a depletion region within the channel 130, 230, $C_{OX}$ denotes capacitance of the insulating electrode 150, 250, that is, a gate insulating film, $C_1$ denotes capacitance of an interface for the channel 130, 230 when the passivation layer 160, 260 is absent, and $C_2$ denotes capacitance of an interface for the channel 130, 230 when the passivation layer 160, 260 is present, that is, between the channel 130, 230 and the passivation layer 160, 260. In more detail, the depletion region represent a region in which charges are absent due to an electric field when a voltage is applied to the gate electrode 140, 240 and the drain electrode 120, 220 of the first FET device 100, the second FET device 200, or the third FET device. For example, the depletion region may be formed in an edge region and a lower region of the channel 130, 230. In this case, the structure of the source electrode 110, 210 - depletion region - gate electrode 140, 240 may be generated, which may act as capacitance within the first FET device 100, the second FET device 200, or the third FET device.

In operation 635, the processor 370 may compare the subthreshold swings of the first FET device 100 and the third FET device, and may detect the first charge amount trapped in the passivation layer 160 of the first FET device 100. In detail, the processor 370 may detect the first charge amount according to the ratio (i.e., $SS_2/SS_1$) of the subthreshold swing of the first FET device 100 to the subthreshold swing of the third FET device. Meanwhile, in operation 637, the processor 370 may compare the subthreshold swings of the second FET device 200 and the third FET device, and may detect the second charge amount trapped in the passivation layer 260 of the second FET device 200. In detail, the processor 370 may detect the second charge amount according to the ratio (i.e., $SS_2/SS_1$) of the subthreshold swing of the second FET device 200 to the subthreshold swing of the third FET device. Here, the ratio (i.e., $SS_2/SS_1$) of the subthreshold swing of the first FET device 100 or the second FET device 200 to the subthreshold swing of the third FET device may be expressed as [Equation 5] below.

[Equation 5]

$$\frac{SS_2}{SS_1} = \frac{1 + C_B + C_1 + \alpha}{1 + C_B + C_1} , \quad C_2 = C_1 + \alpha$$

Here, $\alpha$ denotes a difference value between $C_2$ and $C_1$, and may represent additional capacitance that occurs due to the passivation layer 160, 260. In detail, as the trap increases on the interface between the passivation layer 160, 260 and the channel 130, 230, the additional capacitance, $\alpha$, may be additionally formed and $C_2$ may increase compared to

$C_1$. Therefore, as shown in [Equation 5] above, $SS_2$ increases compared to $SS_1$, and the charge amount trapped in the interface between the passivation layer 160, 260 and the channel 130, 230 may be quantitatively compared through the corresponding increase amount.

In operation 639, the processor 370 may compare the first charge amount and second charge amount, and may assess the quantitative impact of the shape of the passivation layer 160, 260 on the FET device. Here, the processor 370 may compare and analyze the first charge amount and the second charge amount according to the shape of the passivation layer 160, 260, and may compare parameter values according to the shape of the passivation layer 160, 260.

In summary, the present disclosure provides the electronic device 100 for analyzing a FET device that includes the channel 130, 230 of a 2D material and the passivation layer 160, 260 of a high-k material, and an operating method thereof.

Herein, the operating method of the electronic device 100 may include preparing the first FET device 100 in which the passivation layer 160 is arranged in the first direction with respect to the channel 130 and the second FET device 200 in which the passivation layer 260 is arranged in the second direction different from the first direction with respect to the channel 230 (operation 410), and comparing the first charge amount trapped in the passivation layer 160 in the first FET device 100 and the second charge amount trapped in the passivation layer 260 in the second FET device 200, and assessing quantitative impact of the shape of the passivation layer 160, 260 on the FET device (operation 430).

Herein, the operating method of the electronic device 100 may include measuring a drain voltage and a drain current at a low temperature with respect to each of the first FET device 100 and the second FET device 200 (operation 420, operation 521), detecting resistance values in the passivation layer 160, 260 from the drain voltage and the drain current using an equivalent circuit according to the shape of the passivation layer 160, 260 with respect to each of the first FET device 100 and the second FET device 200 (operation 420, operation 523), and quantitatively analyzing the mobility change in the channel 130, 230 based on an increase ratio of the resistance values with respect to each of the first FET device 100 and the second FET device 200 (operation 420, and operation 525), and the increase ratio of the resistance values may represent a ratio of the resistance value of the region covered by the passivation layer 160, 260 of the channel 130, 230 to the resistance value exposed from the passivation layer 160, 260 of the channel 130, 230.

Herein, the equivalent circuit of the first FET device 100 may be expressed as [Equation 1], and the equivalent circuit of the second FET device 200 may be expressed as [Equation 2].

Herein, the operating method of the electronic device 100 may further include preparing the third FET device that includes the channel.

Herein, the assessing of the quantitative impact (operation 430) may include measuring capacitance-voltage characteristics of the first FET device 100, the second FET device 200, and the third FET device, respectively (operation 631), detecting subthreshold swings of the first FET device 100, the second FET device 200, and the third FET device, respectively (operation 633), comparing the subthreshold swings of the first FET device 100 and the third FET device, and detecting the first charge amount of the first FET device 100 (operation 635), comparing the subthreshold swings of the second FET device 200 and the third FET device, and detecting the second charge amount of the second FET device 200 (operation 637), and comparing the first charge amount and the second charge amount, and assessing the quantitative impact (operation 639).

Herein, the subthreshold swing of the third FET device may be detected as in [Equation 3], and the subthreshold swing of each of the first FET device 100 and the second FET device 200 may be detected as in [Equation 4].

Herein, the detecting of the first charge amount (operation 635) may include detecting the first charge amount according to the ratio of the subthreshold swing of the first FET device 100 to the subthreshold swing of the third FET device.

Herein, the detecting of the second charge amount (operation 637) may include detecting the second charge amount according to the ratio of the subthreshold swing of the second FET device 200 to the subthreshold swing of the third FET device.

Herein, the first direction may be a vertical direction that extends parallel to the source electrode 110, 210 and the drain electrode 120, 220 between the source electrode 110, 210 and the drain electrode 120, 220, and the second direction may be a horizontal direction that extends across from the source electrode 110, 210 to the drain electrode 120, 220 between the source electrode 110, 210 and the drain electrode 120, 220.

Herein, the electronic device 100 may include the memory 360, and the processor 370 configured to connect to the memory 360 and to execute at least one instruction stored in the memory 360, and the processor 370 may be configured to prepare the first FET device 100 in which the passivation layer 160 is arranged in the first direction with respect to the channel 130 and the second FET device 200 in which the passivation layer 260 is arranged in the second direction different from the first direction with respect to the channel 230, and to compare the first charge amount trapped in the passivation layer 160 in the first FET device 100 and the second charge amount trapped in the passivation layer 260 in the second FET device 200, and to assess quantitative impact of the shape of the passivation layer 160, 260 on the FET device.

Herein, the processor 370 may be configured to measure a drain voltage and a drain current at low temperature with respect to each of the first FET device 100 and the second FET device 200, to detect resistance values in the passivation layer 160, 260 from the drain voltage and the drain current using an equivalent circuit according to the shape of the passivation layer 160, 260 with respect to each of the first FET device 100 and the second FET device 200, and to quantitatively analyze the mobility change in the channel 130, 230 based on an increase ratio of the resistance values with respect to each of the first FET device 100 and the second FET device 200, and the increase ratio of the resistance values may represent a ratio of the resistance value of the region covered by the passivation layer 160, 260 of the channel 130, 230 to the resistance value exposed from the passivation layer 160, 260 of the channel 130, 230.

Herein, the processor 370 may be configured to prepare the third FET device that includes the channel, to measure capacitance-voltage characteristics of the first FET device 100, the second FET device 200, and the third FET device, respectively, and detect subthreshold swings of the first FET device 100, the second FET device 200, and the third FET device, respectively, to compare the subthreshold swings of the first FET device 100 and the third FET device, and detect the first charge amount of the first FET device 100, to compare the subthreshold swings of the second FET device 200 and the third FET device, and detect the second charge amount of the second FET device 200, and to compare the first charge amount and the second charge amount, and assess the quantitative impact.

According to the present disclosure, by quantitatively comparing and analyzing the impact of the shape of a passivation layer, which is essential in a FET device using a 2D material as a channel, on an electrical characteristic of the FET device, it is possible to find the shape of the passivation layer having an optimal electrical characteristic, which may lead to optimization of the FET device.

The apparatuses described herein may be implemented using hardware components, software components, and/or combination of the hardware components and the software components. For example, the apparatuses and the components described herein may be implemented using one or more general-purpose or special purpose computers, for example, a processor, a controller, an arithmetic logic unit (ALU), a digital signal processor, a microcomputer, a field programmable gate array (FPGA), a programmable logic unit (PLU), a microprocessor, or any other device capable of responding to and executing instructions in a defined manner. The processing device may run an operating system (OS) and one or more software applications that run on the OS. The processing device also may access, store, manipulate, process, and create data in response to execution of the software. For purpose of simplicity, the description of a processing device is used as singular; however, one skilled in the art will be appreciated that the processing device may include multiple processing elements and/or multiple types of processing elements. For example, the processing device may include multiple processors or a processor and a controller. In addition, other processing configurations are possible, such as parallel processors.

The software may include a computer program, a piece of code, an instruction, or some combinations thereof, for independently or collectively instructing or configuring the processing device to operate as desired. Software and/or data may be embodied in any type of machine, component, physical equipment, computer storage medium or device, to provide instructions or data to the processing device or be interpreted by the processing device. The software also may be distributed over network coupled computer systems so that the software is stored and executed in a distributed fashion. The software and data may be stored by one or more computer readable storage mediums.

The methods according to various example embodiments may be implemented in a form of a program instruction executable through various computer methods and recorded in computer-readable media. Here, the media may be to continuously store a computer-executable program or to temporarily store the same for execution or download. The media may be various types of recording methods or storage methods in which a single piece of hardware or a plurality of pieces of hardware are combined and may be distributed over a network without being limited to a medium that is directly connected to a computer system. Examples of the media include magnetic media such as hard disks, floppy disks, and magnetic tapes; optical media such as CD ROM and DVD; magneto-optical media such as floptical disks; and hardware devices that are specially configured to store and perform program instructions, such as read-only memory (ROM), random access memory (RAM), flash memory, and the like. Examples of other media may include recording media and storage media managed by an app store that distributes applications or a site, a server, and the like that supplies and distributes other various types of software.

Various example embodiments and the terms used herein are not construed to limit description disclosed herein to a specific implementation and should be understood to include various modifications, equivalents, and/or substitutions of a corresponding example embodiment. In the drawings, like reference numerals refer to like components throughout the present specification. The singular forms "a," "an," and "the" are intended to include the plural forms as well, unless the context clearly indicates otherwise. Herein, the expressions, "A or B," "at least one of A and/or B," "A, B, or C," "at least one of A, B, and/or C," and the like may include any possible combinations of listed items. Terms "first," "second," etc., are used to describe corresponding components regardless of order or importance and the terms are simply used to distinguish one component from another component. The components should not be limited by the terms. When a component (e.g., first component) is described to be "(functionally or communicatively) connected to" or "accessed to" another component (e.g., second component), the component may be directly connected to the other component or may be connected through still another component (e.g., third component).

According to various example embodiments, each of the components (e.g., module or program) may include a singular object or a plurality of objects. According to various example embodiments, at least one of the components or operations may be omitted. Alternatively, at least one another component or operation may be added. Alternatively or additionally, a plurality of components (e.g., modules or programs) may be integrated into a single component. In this case, the integrated component may perform one or more functions of each of the components in the same or similar manner as it is performed by a corresponding component before integration. According to various example embodiments, operations performed by a module, a program, or another component may be performed in a sequential, parallel, iterative, or heuristic manner. Alternatively, at least one of the operations may be performed in different sequence or omitted. Alternatively, at least one another operation may be added.

**Claims**

1. An operating method of an electronic device for analyzing a field effect transistor (FET) device that includes a channel of a two-dimensional (2D) material and a passivation layer of a high-k material, the operating method comprising:

   preparing a first FET device in which the passivation layer is arranged in a first direction with respect to the channel and a second FET device in which the passivation layer is arranged in a second direction different from the first direction with respect to the channel; and
   comparing the first charge amount trapped in the passivation layer in the first FET device and the second charge amount trapped in the passivation layer in the second FET device, and assessing quantitative impact of the shape of the passivation layer on the FET device.

2. The operating method of claim 1, further comprising:

   measuring a drain voltage and a drain current at low temperature with respect to each of the first FET device and the second FET device;
   detecting resistance values in the passivation layer from the drain voltage and the drain current using an equivalent circuit according to the shape of the passivation layer with respect to each of the first FET device and the second FET device; and
   quantitatively analyzing the mobility change in the channel based on an increase ratio of the resistance values with respect to each of the first FET device and the second FET device,
   wherein the increase ratio of the resistance values represents a ratio of a resistance value of a region covered by the passivation layer of the channel to a resistance value of a region exposed from the passivation layer of the channel.

3. The operating method of claim 2, wherein:

   the equivalent circuit of the first FET device is expressed as [Equation i] below, and
   the equivalent circuit of the second FET device is expressed as [Equation ii] below,

   [Equation i]

   $$\frac{V_D}{I_D} = R_{tot} = 3R_1 + 2R_2$$

   [Equation ii]

   $$\frac{V_D}{I_D} = \frac{1}{R_{tot}} = \frac{3}{R_1} + \frac{2}{R_2}$$

   where $V_D$ denotes the drain voltage, $I_D$ denotes the drain current, $R_{tot}$ denotes a total resistance value, $R_1$ denotes

the resistance value of the region exposed from the passivation layer of the channel, and $R_2$ denotes the resistance value of the region covered by the passivation layer of the channel.

4. The operating method of claim 1, further comprising:

preparing a third FET device that includes the channel,
wherein the assessing of the quantitative impact comprises:

measuring capacitance-voltage characteristics of the first FET device, the second FET device, and the third FET device, respectively, and detecting subthreshold swings of the first FET device, the second FET device, and the third FET device, respectively;
comparing the subthreshold swings of the first FET device and the third FET device, and detecting the first charge amount of the first FET device;
comparing the subthreshold swings of the second FET device and the third FET device, and detecting the second charge amount of the second FET device; and
comparing the first charge amount and the second charge amount, and assessing the quantitative impact.

5. The operating method of claim 4, wherein:

the subthreshold swing of the third FET device is detected as in [Equation iii] below, and
the subthreshold swing of each of the first FET device and the second FET device is detected as in [Equation iv] below,

[Equation iii]

$$ SS_1 = 2.3kT(1 + \frac{C_B + C_1}{C_{OX}}) $$

[Equation iv]

$$ SS_2 = 2.3kT(1 + \frac{C_B + C_2}{C_{OX}}) $$

where $SS_1$ denotes the subthreshold swing of the third FET device, $SS_2$ denotes the subthreshold swing of the first FET device or the second FET device, kT denotes Boltzmann constant, $C_B$ denotes depletion region capacitance, $C_{OX}$ denotes insulating electrode capacitance, $C_1$ denotes interfacial capacitance when the passivation layer is absent, and $C_2$ denotes interfacial capacitance when the passivation layer is present.

6. The operating method of claim 4, wherein:

the detecting of the first charge amount comprises detecting the first charge amount according to the ratio of the subthreshold swing of the first FET device to the subthreshold swing of the third FET device, and
the detecting of the second charge amount comprises detecting the second charge amount according to the ratio of the subthreshold swing of the second FET device to the subthreshold swing of the third FET device.

7. The operating method of claim 1, wherein:

the first direction is a vertical direction that extends parallel to a source electrode and a drain electrode between the source electrode and the drain electrode, and
the second direction is a horizontal direction that extends across from the source electrode to the drain electrode between the source electrode and the drain electrode.

8. An electronic device for analyzing a field effect transistor (FET) device that includes a channel of a two-dimensional (2D) material and a passivation layer of a high-k material, the electronic device comprising:

a memory; and
a processor configured to connect to the memory and to execute at least one instruction stored in the memory, wherein the processor is configured to,
prepare a first FET device in which the passivation layer is arranged in a first direction with respect to the channel and a second FET device in which the passivation layer is arranged in a second direction different from the first direction with respect to the channel, and
compare the first charge amount trapped in the passivation layer in the first FET device and the second charge amount trapped in the passivation layer in the second FET device, and assess quantitative impact of the shape of the passivation layer on the FET device.

9. The electronic device of claim 8, wherein the processor is configured to, measure a drain voltage and a drain current at low temperature with respect to each of the first FET device and the second FET device,

detect resistance values in the passivation layer from the drain voltage and the drain current using an equivalent circuit according to the shape of the passivation layer with respect to each of the first FET device and the second FET device, and
quantitatively analyze the mobility change in the channel based on an increase ratio of the resistance values with respect to each of the first FET device and the second FET device, and
the increase ratio of the resistance values represents a ratio of a resistance value of a region covered by the passivation layer of the channel to a resistance value of a region exposed from the passivation layer of the channel.

10. The electronic device of claim 8, wherein the processor is configured to, prepare a third FET device that includes the channel,

measure capacitance-voltage characteristics of the first FET device, the second FET device, and the third FET device, respectively, and detect subthreshold swings of the first FET device, the second FET device, and the third FET device, respectively,
compare the subthreshold swings of the first FET device and the third FET device, and detect the first charge amount of the first FET device,
compare the subthreshold swings of the second FET device and the third FET device, and detect the second charge amount of the second FET device, and
compare the first charge amount and the second charge amount, and assess the quantitative impact.

**Amended claims in accordance with Rule 137(2) EPC.**

1. An operating method of an electronic device for analyzing a field effect transistor (FET) device that includes a channel of a two-dimensional (2D) material and a passivation layer of a high-k material, the operating method comprising:

preparing a first FET device in which the passivation layer is arranged in a first direction with respect to the channel and a second FET device in which the passivation layer is arranged in a second direction different from the first direction with respect to the channel, wherein the first direction is a vertical direction that extends parallel to a source electrode and a drain electrode between the source electrode and the drain electrode, and the second direction is a horizontal direction that extends across from the source electrode to the drain electrode between the source electrode and the drain electrode;
preparing a third FET device that includes the channel of the 2D material but does not include the passivation layer;
measuring a drain voltage and a drain current at a temperature in a range of 100 K to 300 K, detecting a first resistance value ($R_1$) of a region exposed from the passivation layer and a second resistance value ($R_2$) of a region covered by the passivation layer using an equivalent circuit with respect to each of the first FET device and the second FET device, and quantitatively analyzing a mobility change in the channel based on an increase ratio of the second resistance value ($R_2$) to the first resistance value ($R_1$);
measuring capacitance-voltage characteristics of the first FET device, the second FET device, and the third FET device, respectively, and detecting subthreshold swings of the first FET device, the second FET device, and the third FET device, respectively;

detecting a first charge amount trapped in the passivation layer in the first FET device based on a first ratio of the subthreshold swing of the first FET device to the subthreshold swing of the third FET device, wherein the first ratio corresponds to a first additional capacitance generated by the passivation layer to quantify the first charge amount trapped at an interface between the passivation layer and the channel; detecting a second charge amount trapped in the passivation layer in the second FET device based on a second ratio of the subthreshold swing of the second FET device to the subthreshold swing of the third FET device, wherein the second ratio corresponds to a second additional capacitance generated by the passivation layer to quantify the second charge amount trapped at the interface between the passivation layer and the channel; and comparing the first charge amount and the second charge amount, and assessing quantitative impact of the arrangement direction of the passivation layer on the FET device.

2. The operating method of claim 1, wherein:

the equivalent circuit of the first FET device is expressed as [Equation i] below, and the equivalent circuit of the second FET device is expressed as [Equation ii] below,

[Equation i]

$$\frac{V_D}{I_D} = R_{tot} = 3R_1 + 2R_2$$

[Equation ii]

$$\frac{I_D}{V_D} = \frac{1}{R_{tot}} = \frac{3}{R_1} + \frac{2}{R_2}$$

where $V_D$ denotes the drain voltage, $I_D$ denotes the drain current, $R_{tot}$ denotes a total resistance value, $R_1$ denotes the resistance value of the region exposed from the passivation layer of the channel, and $R_2$ denotes the resistance value of the region covered by the passivation layer of the channel.

3. The operating method of claim 1, wherein:

the subthreshold swing of the third FET device is detected as in [Equation iii] below, and the subthreshold swing of each of the first FET device and the second FET device is detected as in [Equation iv] below,

[Equation iii]

$$SS_1 = 2.3kT(1 + \frac{C_B + C_1}{C_{OX}})$$

[Equation iv]

$$SS_2 = 2.3kT(1 + \frac{C_B + C_2}{C_{OX}})$$

where $SS_1$ denotes the subthreshold swing of the third FET device, $SS_2$ denotes the subthreshold swing of the first FET device or the second FET device, kT denotes Boltzmann constant, $C_B$ denotes depletion region capacitance, $C_{OX}$ denotes insulating electrode capacitance, $C_1$ denotes interfacial capacitance when the passivation layer is absent, and $C_2$ denotes interfacial capacitance when the passivation layer is present.

**4.** An electronic device for analyzing a field effect transistor (FET) device that includes a channel of a two-dimensional (2D) material and a passivation layer of a high-k material, the electronic device comprising:

a memory; and
a processor configured to connect to the memory and to execute at least one instruction stored in the memory, wherein the processor is configured to,
acquire electrical measurement data of a first FET device in which the passivation layer is arranged in a first direction with respect to the channel, a second FET device in which the passivation layer is arranged in a second direction different from the first direction with respect to the channel, and a third FET device that includes the channel of the 2D material but does not include the passivation layer, wherein the first direction is a vertical direction that extends parallel to a source electrode and a drain electrode between the source electrode and the drain electrode, and the second direction is a horizontal direction that extends across from the source electrode to the drain electrode between the source electrode and the drain electrode,
detect a first resistance value ($R_1$) of a region exposed from the passivation layer and a second resistance value ($R_2$) of a region covered by the passivation layer using an equivalent circuit based on a drain voltage and a drain current measured at a temperature in a range of 100 K to 300 K included in the electrical measurement data with respect to each of the first FET device and the second FET device, and quantitatively analyze a mobility change in the channel based on an increase ratio of the second resistance value ($R_2$) to the first resistance value ($R_1$);
detect subthreshold swings of the first FET device, the second FET device, and the third FET device, respectively, based on capacitance-voltage characteristics of the first FET device, the second FET device, and the third FET device included in the electrical measurement data;
detect the first charge amount trapped in the passivation layer in the first FET device based on a first ratio of the subthreshold swing of the first FET device to the subthreshold swing of the third FET device, wherein the first ratio corresponds to a first additional capacitance generated by the passivation layer to quantify the first charge amount trapped at an interface between the passivation layer and the channel;
detect the second charge amount trapped in the passivation layer in the second FET device based on a second ratio of the subthreshold swing of the second FET device to the subthreshold swing of the third FET device, wherein the second ratio corresponds to a second additional capacitance generated by the passivation layer to quantify the second charge amount trapped at the interface between the passivation layer and the channel; and
compare the first charge amount and the second charge amount, and assess quantitative impact of the arrangement direction of the passivation layer on the FET device.

FIG. 1

(a)

(b)

(c)

FIG. 2

<u>200</u>

(a)

(b)

(c)

FIG. 3

Electronic device(300)

Camera module
(310)

Output module
(340)

Communication
module
(320)

Memory
(360)

Input module
(330)

Processor
(370)

Measurement
module
(350)

FIG. 4

```
                    ┌─────────────┐
                    │    Start    │
                    └──────┬──────┘
                           │
                           ▼
┌────────────────────────────────────────────────────────┐
│  Prepare first FET device, second FET device, and third │──── 410
│                    FET device                           │
└───────────────────────────┬────────────────────────────┘
                            │
                            ▼
┌────────────────────────────────────────────────────────┐
│   Analyze intrinsic characteristics of passivation      │
│   layer using cryogenic measurement and equivalent      │──── 420
│   circuit according to shape of passivation layer,      │
│   with respect to each of first FET device              │
│                and second FET device                    │
└───────────────────────────┬────────────────────────────┘
                            │
                            ▼
┌────────────────────────────────────────────────────────┐
│  Assess quantitative impact of shape of passivation     │
│  layer on FET device through first FET device,          │──── 430
│  second FET device,                                     │
│               and third FET device                      │
└───────────────────────────┬────────────────────────────┘
                            │
                            ▼
                    ┌─────────────┐
                    │     End     │
                    └─────────────┘
```

FIG. 5

( 410 )

Measure drain voltage and drain current at low temperature — 521

Detect resistance values in passivation layer from drain voltage and drain current using equivalent circuit according to shape of passivation layer — 523

Quantitatively analyze mobility change in channel based on increase ratio of resistance values — 525

( 430 )

FIG. 6

( 420 )

Measure capacitance-voltage characteristics of first FET device, second FET device, and third FET device, respectively — 631

Detect subthreshold swings of first FET device, second FET device, and third FET device, respectively — 633

Compare subthreshold swings of first FET device and third FET device, and detect first charge amount of first FET device — 635

Compare subthreshold swings of second FET device and third FET device, and detect second charge amount of second FET device — 637

Compare first charge amount and second charge amount, and assess quantitative impact. — 639

( End )

**EUROPEAN SEARCH REPORT**

Application Number

EP 25 20 6434

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 210 999 B1 (GARDNER MARK I [US] ET AL) 3 April 2001 (2001-04-03) | 1,3-10 | INV. G01R31/26 |
| Y | * column 1, line 9 - line 17 * <br> * column 8, last paragraph - column 9, line 19 * | 2 | ADD. H10P74/20 H10P74/00 |
| | ----- | | |
| Y | CN 112 955 760 B (UNIV PEKING SHENZHEN GRADUATE SCHOOL) 31 May 2022 (2022-05-31) | 2 | |
| A | * paragraphs [0001], [0042] - paragraph [0086]; figures 4-6 * | 1,3-10 | |
| | ----- | | |
| A | JP 2020 031171 A (NAT INST MATERIALS SCIENCE; UNIV TSUKUBA) 27 February 2020 (2020-02-27) <br> * paragraphs [0001] - [0003], [0033] - paragraph [0045]; figures 2a,2b,3 * | 1-10 | |
| | ----- | | |
| A | TROJMAN L ET AL: "Mobility and Dielectric Quality of 1-nm EOT HfSiON on Si(110) and (100)", IEEE TRANSACTIONS ON ELECTRON DEVICES, IEEE, USA, vol. 55, no. 12, 1 December 2008 (2008-12-01), pages 3414-3420, XP011238105, ISSN: 0018-9383, DOI: 10.1109/TED.2008.2006548 * abstract; figures 1-3 * | 1-10 | **TECHNICAL FIELDS SEARCHED (IPC)** <br><br> G01R H10P |
| | ----- | | |

The present search report has been drawn up for all claims

| Place of search | Date of completion of the search | Examiner |
|---|---|---|
| Munich | 10 March 2026 | Hof, Klaus-Dieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

EP 4 764 517 A1

## ANNEX TO THE EUROPEAN SEARCH REPORT
## ON EUROPEAN PATENT APPLICATION NO.

EP 25 20 6434

10-03-2026

| Patent document cited in search report | | Publication date | Patent family member(s) | | Publication date |
|---|---|---|---|---|---|
| US 6210999 | B1 | 03-04-2001 | NONE | | |
| CN 112955760 | B | 31-05-2022 | CN | 112955760 A | 11-06-2021 |
| | | | US | 2022018888 A1 | 20-01-2022 |
| | | | WO | 2021077684 A1 | 29-04-2021 |
| JP 2020031171 | A | 27-02-2020 | JP | 7083112 B2 | 10-06-2022 |
| | | | JP | 2020031171 A | 27-02-2020 |

EPO FORM P0459

For more details about this annex : see Official Journal of the European Patent Office, No. 12/82